# FASCICULE DE BREVET EUROPEEN

(11) **EP 1 417 504 B1**
(45) Date de publication et mention de la délivrance du brevet: **09.05.2007**
(21) Numéro de dépôt: 02772503.5
(22) Date de dépôt: 13.08.2002
(51) Int. Cl.: G01R 33/04

(54) **PROCEDE DE STABILISATION D'UN SIGNAL DE MAGNETOMETRE, ET MAGNETOMETRES STABILISES**
VERFAHREN ZUM STABILISIEREN EINES MAGNETOMETERSIGNALS UND STABILISIERTE MAGNETOMETER
METHOD OF STABILISING A MAGNETOMETER SIGNAL AND STABILISED MAGNETOMETERS

(30) Priorité: 16.08.2001 FR 0110853
(43) Date de publication de la demande: 12.05.2004
(73) Titulaire: COMMISSARIAT A L'ENERGIE ATOMIQUE, 75015 Paris (FR)
(72) Inventeur: GUILHAMAT, Bernard, F-38590 Saint Michel de Saint Geoirs (FR); LEGER, Jean-Michel, F-38190 Villard-Bonnot (FR)
(74) Mandataire: Poulin, Gérard
(86) Numéro de dépôt international: PCT/FR2002/002869
(87) Numéro de publication internationale: WO 2003/016933

(56) Documents cités:
- EP-A- 1 039 307
- US-A- 4 995 165
- US-A- 5 939 881
- PIIL-HENRIKSEN J ET AL: "DIGITAL DETECTION AND FEEDBACK FLUXGATE MAGNETOMETER" , MEASUREMENT SCIENCE AND TECHNOLOGY, IOP PUBLISHING, BRISTOL, GB, VOL. 7, NR. 6, PAGE(S) 897-903 XP000597056 ISSN: 0957-0233 colonne 1, ligne 8 - ligne 17 colonne 6, ligne 15 - ligne 32 figures 1,5
- LIAKOPOULOS T M ET AL: "A micro-fluxgate magnetic sensor using micromachined planar solenoid coils" , SENSORS AND ACTUATORS A, ELSEVIER SEQUOIA S.A., LAUSANNE, CH, VOL. 77, NR. 1, PAGE(S) 66-72 XP004244548 ISSN: 0924-4247 colonne 3 -colonne 7 figures 1,3,6
- RIPKA P: "Race-track fluxgate with adjustable feedthrough" , SENSORS AND ACTUATORS A, ELSEVIER SEQUOIA S.A., LAUSANNE, CH, VOL. 85, NR. 1-3, PAGE(S) 227-231 XP004214475 ISSN: 0924-4247 le document en entier

## Description

Le sujet de cette invention est un procédé de stabilisation d'un signal de magnétomètre ainsi que des magnétomètres ainsi stabilisés.

Les magnétomètres du genre ici considéré (« fluxgate ») comprennent un noyau magnétique, au moins un bobinage actif enroulé autour du noyau, par lequel passe un courant d'excitation créant un champ magnétique dans le noyau, et un bobinage récepteur à deux enroulements en série, lui aussi enroulé autour du noyau et muni de moyens de mesure de la tension à ses bornes. Le plus souvent, le noyau est un noyau comprenant deux branches reliées en série, les enroulements du bobinage récepteur sont respectivement disposés autour des branches, et on trouve deux bobinages actifs dont chacun comprend deux enroulements respectivement disposés autour des branches. Les bobinages actifs sont alors enroulés de la même façon autour de chacune des branches mais à l'opposé d'une branche à l'autre, de manière que leurs effets se renforcent et engendrent un champ magnétique de circulation dans le noyau ; mais le bobinage récepteur est enroulé de manière que le champ magnétique produit par les bobinages actifs induise des courants opposés dans ses deux enroulements, et qui s'annulent.

Les magnétomètres ainsi construits ont la particularité d'être insensibles au premier ordre au champ magnétique produit par le courant excitateur, mais d'être sensibles à des champs magnétiques ambiants, qui interagissent avec le champ magnétique d'excitation, pour peu que ce dernier ait une intensité suffisante : un courant induit, d'une fréquence double de celle du courant d'excitation et d'une intensité proportionnelle à celle du champ magnétique ambiant, parcourt le bobinage récepteur du magnétomètre et peut être mesuré.

D'autres magnétomètres, moins perfectionnés, ne comprennent pas de montage en différentiel d'enroulements en série du bobinage récepteur et mesurent un courant induit comprenant la fréquence d'excitation et la fréquence double ; l'invention pourra aussi leur être appliquée.

Le document XP 0042 44 548 (Liakopoulos et al : « A micro-fluxgate sensor using micromachined planar solenoid coils », Sensors and Actuators A, Elsevier Sequoia S.A., Lausanne, vol. 77, N°1, P. 66-72) décrit un magnétomètre du genre mentionné.

Les documents US-A-5 931 881 et XP 00 059 70 56 (PIIL - HENRIKSEN J. ET AL : « Digital detection and feedback fluxgate magnetometer », Measurement science and technology, IOP Publishing, Bristol, vol. 7, N°6, p 897-903) décrivent des magnétomètres à bobinage de compensation du signal, de mesure qui produisent un champ magnétique auquel le bobinage de mesure est forcément sensible.

Les inventeurs ont toutefois constaté que ces magnétomètres étaient sujets à des bruits non négligeables de basse fréquence et qui étaient susceptibles de brouiller ou de masquer le signal induit représentatif du champ magnétique à mesurer. Ils ont donc cherché à stabiliser le signal de sortie total en réduisant ce bruit. La solution qu'ils proposent ici consiste à soumettre le bobinage récepteur à un champ magnétique alternatif supplémentaire, auquel les moyens de mesure sont insensibles, selon les éléments de la revendication 1.

Ce champ magnétique additionnel peut avoir une direction quelconque, mais une direction perpendiculaire au champ d'excitation est préférée.

L'invention sera maintenant décrite en référence aux figures:
- la figure 1 est une vue générale du magnétomètre,
- la figure 2 représente un bruit obtenu sans la mise en oeuvre de l'invention,
- la figure 3 est un diagramme de fréquence,
- et les figures 4, 5 et 6 représentent trois modes de réalisation de l'invention.

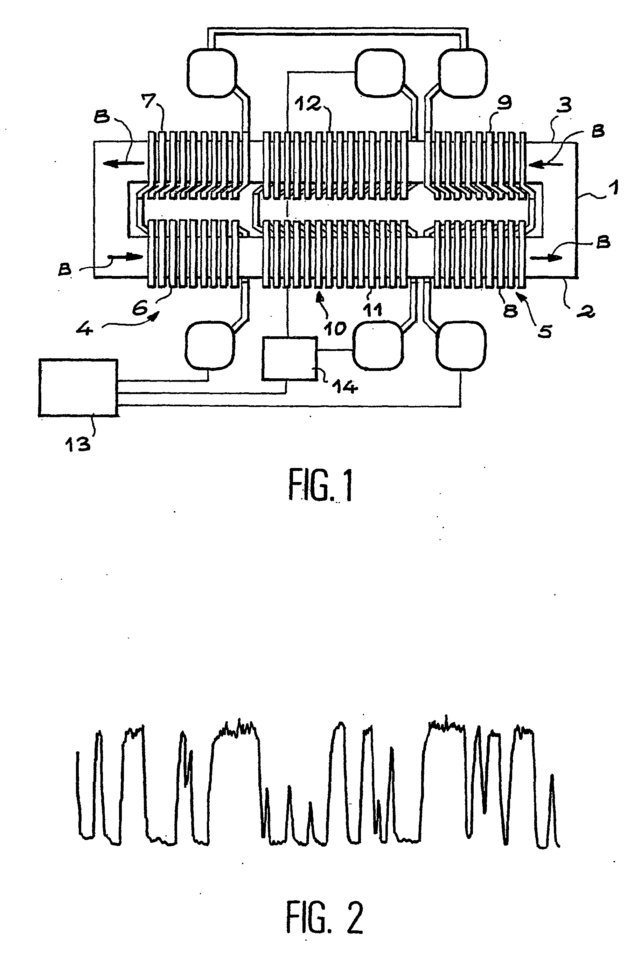

Le magnétomètre différentiel de la figure 1 est du genre le plus fréquent et comprend un noyau magnétique 1 et en forme rectangulaire avec deux branches principales 2 et 3 en série. Trois bobinages sont enroulés autour du noyau 1, et plus précisément deux bobinages actifs 4 et 5 comprenant chacun deux enroulements 6, 7 et 8, 9 autour respectivement des branches 2 et 3, ainsi qu'un bobinage récepteur 10 composé de deux enroulements 11 et 12 encore autour des branches 2 et 3 respectivement. Les bobinages 4 et 5 actifs sont reliés en série dans un circuit aboutissant à un dispositif d'excitation 13, et le bobinage récepteur est aux bornes d'un dispositif de mesure 14.

Les enroulements 6 et 8 sont formés dans un même sens autour de la branche 2, et les enroulements 7 et 9 dans un sens opposé autour de l'autre branche 3 de manière à créer un champ magnétique B apte à circuler dans le noyau magnétique lorsque celui-ci est fermé, comme l'est le noyau 1.

Quand le circuit magnétique est ouvert, un champ magnétique circule dans chacune des branches et les sens de ces deux champs magnétiques sont opposées.

Les enroulements 11 et 12 du bobinage récepteur 10 sont dans le même sens, alors que les enroulements 6 et 8 ont des sens opposés aux enroulements 7 et 9.

Les moyens d'excitation sont aptes à fournir un courant d'excitation à une fréquence déterminée et peuvent comprendre un oscillateur, un diviseur de fréquence par deux, un convertisseur d'onde carrée en onde triangulaire et un convertisseur de tension en courant. Les moyens de mesure 14 comprennent un préamplificateur recueillant la tension aux bornes du bobinage récepteur 10, un détecteur synchrone alimenté par le signal de l'oscillateur non divisé par deux, un filtre passe-bas, un correcteur proportionnel-intégral-différentiel, un amplificateur, un filtre passe-bas associé aux moyens d'affichage et pour permettre la persistance rétinienne à fréquence de coupure de l'ordre d'un hertz, et des moyens d'affichage. Un courant de contre-réaction peut être appliqué aux bornes du bobinage de mesure 10 en prélevant la tension à la sortie du module de correction et en la convertissant en courant. On ne s'étendra pas plus sur ces éléments déjà divulgués et d'ailleurs assez simples, et qui permettent de prélever le signal induit à une fréquence double de la fréquence d'excitation et de le convertir en signal continu avant de le transmettre aux moyens d'affichage, qui le mesurent.

La figure 2 montre que le signal à vide obtenu avec un tel magnétomètre comprend des oscillations d'une amplitude pouvant atteindre 2 microteslas environ dans cet exemple, essentiellement entre deux valeurs extrêmes, sans périodicité marquée mais concentrées aux très basses fréquences. L'échantillon représenté couvre une durée de 30 secondes. Comme l'amplitude du signal à mesurer n'est souvent guère supérieure à ce bruit, on conçoit que la mesure est très brouillée et qu'une amélioration est demandée.

Selon l'invention, un champ magnétique supplémentaire est imposé pour stabiliser la mesure. Il peut être de 350 microteslas pour une fréquence de 60 kilohertz quand le champ produit par la fréquence d'excitation est de 0,9 tesla. On n'a pas remarqué d'autres exigences particulières pour obtenir une réduction sensible du bruit à très basse fréquence, de sorte que le champ supplémentaire de stabilisation peut être produit de différentes façons et avoir des directions différentes.

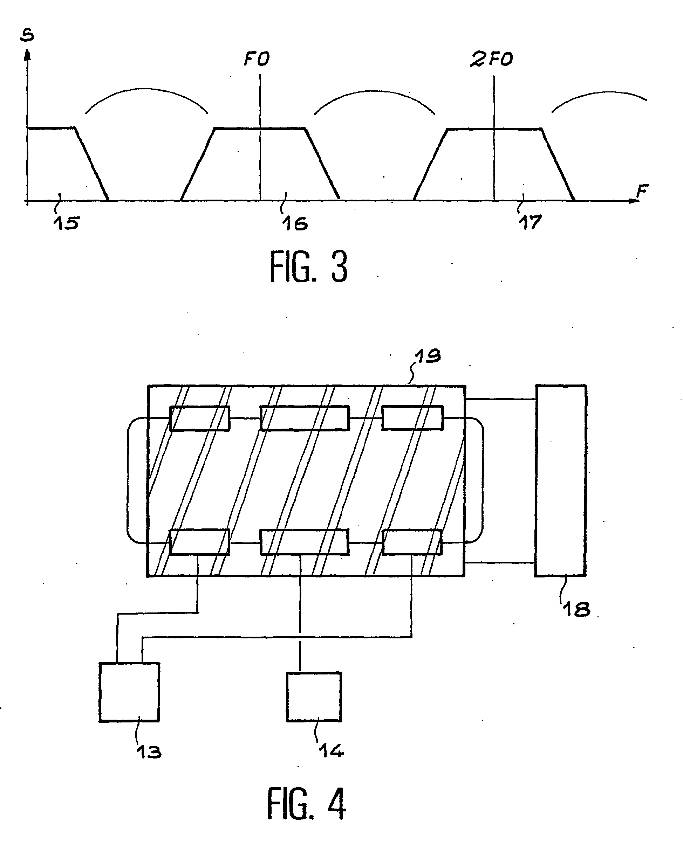

Dans une forme de réalisation de l'invention, représentée à la figure 4, un bobinage 19 supplémentaire est disposé autour du magnétomètre, des deux branches 2 et 3 et de tous les autres bobinages rencontrés auparavant, et des moyens d'excitation supplémentaires 18 sont disposés à ses extrémités pour produire le champ supplémentaire.

Toutefois si le champ de stabilisation est parallèle au champs de mesure, on rencontre l'inconvénient que le champs de stabilisation peut éblouir ou saturer les moyens de mesure du fait du chevauchement des bandes de fréquences.

Se reportant à la figure 3, qui est un diagramme de fréquences, on a désigné par 15 la bande passante du signal ambiant susceptible d'être alors détecté, par 16 la bande passante d'excitation et par 17 la bande passante de mesure, dans laquelle le signal induit est recueilli. Ces bandes 15, 16 et 17 sont à peu prés équidistantes, la bande 15 regroupant les basses fréquences et la bande 17 étant aux fréquences doubles de la bande 16.

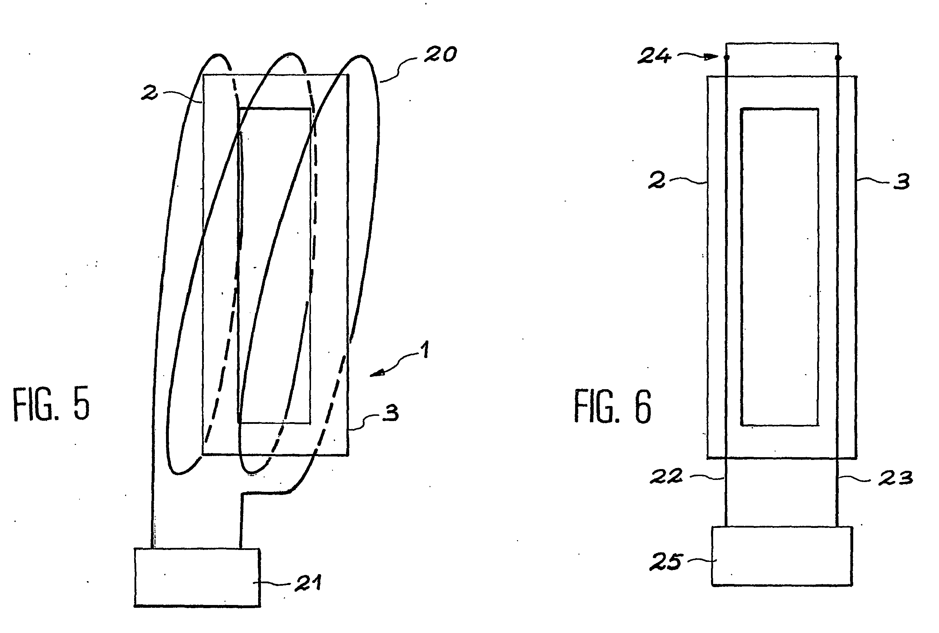

Il est donc conseillé, en ajoutant un moyen spécial pour créer le champ supplémentaire, de le disposer pour que ce champ soit perpendiculaire au champ d'excitation. La figure 5 illustre une telle disposition : un bobinage supplémentaire 20, alimenté par des moyens d'excitation supplémentaires 21 à ses extrémités, est orienté de façon que son axe coupe les branches 2 et 3 du noyau 1, .contrairement à la disposition de la figure 4.

Au lieu d'un bobinage supplémentaire unique tel 19 ou 20, on pourrait utiliser plusieurs bobinages supplémentaires, qui seraient orientés de façon à créer un champ supplémentaire résultant dans la direction choisie. Au lieu de bobinages, un fil conducteur parcouru par un courant suffit pour créer le champ supplémentaire. Une réalisation particulière apparaît à la figure 6, où on utilise deux fils 22 et 23, respectivement proches des branches 2 et 3, et parallèles à elles afin que le champ supplémentaire, perpendiculaire aux fils 22 et 23, le soit aussi au champ d'excitation B. Les fils 22 et 23 peuvent être parcourus par des courants en phase ou déphasés ; il est donc possible de les unir en un circuit 24 unique et pourvu d'un moyen d'excitation 25 commun.

La fréquence du champ supplémentaire de stabilisation sera avantageusement inférieure à la fréquence de la bande 16 (du courant d'excitation). Toutefois, elle pourra être quelconque si le champ supplémentaire est perpendiculaire au champ d'excitation ou si on a pu éliminer complètement les signaux induits à la fréquence d'excitation dans le bobinage, par une construction rigoureusement symétrique des branches du magnétomètre ou par un dispositif de compensation ; la fréquence du champ supplémentaire de stabilisation pourra même être dans la bande de mesure 17.

Mais si le .champ supplémentaire était parallèle au champ d'excitation (et à la direction du champ ambiant auquel le magnétomètre est sensible), il aurait convenu de prendre des précautions supplémentaires et de choisir la fréquence de ce champ supplémentaire hors de la bande de détection 15 de la bande d'excitation 16 et de la bande de mesure 17.

Si le magnétomètre n'est pas monté en différentiel, il sera préférable de choisir une des réalisations au champ magnétique supplémentaire perpendiculaire au champ d'excitation et au bobinage récepteur.

## Revendications

1. Procédé de stabilisation d'un magnétomètre comprenant un noyau magnétique (1), des bobinages dont au moins un bobinage actif (4, 5) et un bobinage récepteur (10), le bobinage actif étant agencé de façon à créer un champ magnétique (B) d'excitation dans le noyau, qui sensibilise le bobinage récepteur, des moyens de passage (13) d'un courant alternatif à une fréquence d'excitation dans le bobinage actif et des moyens de mesure (14) d'une tension induite à une fréquence double de la fréquence d'excitation dans le bobinage récepteur, **caractérisé en ce qu'**il consiste à soumettre le bobinage récepteur à un champ magnétique alternatif supplémentaire produit par un moyen supplémentaire du magnétomètre, auquel les moyens de mesure (14) sont insensibles, ledit champ magnétique alternatif supplémentaire ayant une direction différente du champ d'excitation.

2. Procédé selon la revendication 1, **caractérisé en ce que** le champ magnétique supplémentaire est perpendiculaire au bobinage récepteur et au champ d'excitation.

3. Procédé selon la revendication 1 ou 2 **caractérisé en ce que** le champ magnétique supplémentaire a une fréquence hors d'une bande de fréquences d'excitation (16), d'une bande de mesure (17) et d'une bande de détection (15).

4. Magnétomètre comprenant un noyau magnétique (1), des bobinages dont au moins un bobinage actif (4, 5) et un bobinage récepteur (10), le bobinage actif étant agencé de façon à créer un champ magnétique (B) d'excitation dans le noyau, qui sensibilise le bobinage récepteur, des moyens de passage (13) d'un courant alternatif à une fréquence d'excitation dans le bobinage actif et des moyens de mesure (14) d'une tension induite à une fréquence double de la fréquence d'excitation dans le bobinage récepteur, **caractérisé en ce qu'**il comprend au moins un fil conducteur (22, 23) parcouru par un courant pour produire un champ magnétique alternatif supplémentaire auquel les moyens de mesure (14) sont insensibles, ledit champ magnétique alternatif supplémentaire ayant une direction différente du champ d'excitation.

5. Magnétomètre selon la revendication 4 **caractérisé en ce que** le fil conducteur est un bobinage (19, 20) entourant le noyau magnétique (1).

6. Magnétomètre suivant la revendication 4, **caractérisé en ce qu'**il comprend autant de fils conducteurs que le noyau (1) comprend de branches (2, 3), les fils étant respectivement proches des branches et parallèles aux branches.

## Claims

1. Method of stabilizing a magnetometer including a magnetic core (1), coils including at least one active coil (4, 5) and one take-up coil (10), the active coil being arranged in such a way as to create a magnetic excitation field (B) in the core, which sensitizes the take-up coil, means (13) of passing an alternating current at an excitation frequency in the active coil and means (14) of measuring a voltage induced at a frequency double the excitation frequency in the take-up coil, **characterized in that** it consists in subjecting the take-up coil to an additional alternating magnetic field, to which the measurement means (14) are insensitive, said additional alternating magnetic field having a different direction to the excitation field.

2. Method according to claim 1, **characterized in that** the additional magnetic field is perpendicular to the take-up coil and to the excitation field.

3. Method according to claim 1 or 2, **characterized in that** the additional magnetic field has a frequency outside a band of excitation frequencies (16), a measurement band (17) and a detection band (15).

4. Magnetometer comprising a magnetic core (1), coils including at least one active coil (4, 5) and one take-up coil (10), the active coil being arranged in such a way as to create a magnetic excitation field (B) in the core, which sensitizes the take-up coil, means (13) of passing an alternating current at an excitation frequency into the active coil and means (14) for measuring a voltage induced at a frequency twice the excitation frequency in the take-up coil, **characterized in that** it comprises at least one conductor wire (22, 23) traversed by a current for producing an additional alternating magnetic field to which the measurement means (14) are insensitive, said additional alternating magnetic field having a different direction to the excitation field.

5. Magnetometer according to claim 4, **characterized in that** the conductor wire is a coil (19, 20) surrounding the magnetic core (1).

6. Magnetometer according to claim 4, **characterized in that** it has the same number of conductor wires as the core (1) has branches (2, 3), the wires being respectively close to and parallel to the branches.

## Patentansprüche

1. Verfahren zum Stabilisieren eines Magnetometers mit einem Metallkern (1), mindestens eine aktive Wicklung (4, 5) umfassenden Wicklungen und einer Empfängerwicklung (10), wobei die aktive Wicklung so angeordnet ist, dass sie in dem Kern ein die Empfängerspule sensibilisierendes Erregermagnetfeld (B) erzeugt, mit Einrichtungen (13) zum Erzeugen eines Wechselstromflusses mit einer Erregerfrequenz in der aktiven Spule, und mit Einrichtungen (14) zum Messen einer Spannung, induziert mit einer Frequenz doppelt so hoch wie die Erregerfrequenz in der Empfängerwicklung,
**dadurch gekennzeichnet, dass** es darin besteht, die Empfängerwicklung einem zusätzlichen magnetischen Wechselfeld auszusetzen, erzeugt durch eine zusätzliche Einrichtung des Magnetometers, auf das die Messeinrichtungen (14) nicht ansprechen, wobei das genannte magnetische Wechselfeld eine andere Richtung als das Erregerfeld hat.

2. Verfahren nach Anspruch 1, **dadurch gekennzeichnet, dass** das zusätzliche Magnetfeld senkrecht ist zu der Empfängerwicklung und zu dem Erregerfeld.

3. Verfahren nach Anspruch 1 oder 2, **dadurch gekennzeichnet, dass** das zusätzliche Magnetfeld eine Frequenz außerhalb eines Erregerfrequenzenbands (16), eines Messbands (17) und eines Detektionsbands (15) hat.

4. Magnetometer mit einem Metallkern (1), mindestens eine aktive Wicklung (4, 5) umfassenden Wicklungen und einer Empfängerwicklung (10), wobei die aktive Wicklung so angeordnet ist, dass sie in dem Kern ein die Empfängerspule sensibilisierendes Erregermagnetfeld (B) erzeugt, mit Einrichtungen (13) zum Erzeugen eines Wechselstromflusses mit einer Erregerfrequenz in der aktiven Spule, und mit Einrichtungen (14) zum Messen einer Spannung induziert mit einer Frequenz doppelt so hoch wie die Erregerfrequenz in der Empfängerwicklung, **dadurch gekennzeichnet, dass** es mindestens einen leitfähigen Draht (22, 23) umfasst, den ein Strom durchfließt, um ein zusätzliches magnetisches Wechselfeld zu erzeugen, auf das die Messeinrichtungen (14) nicht ansprechen, wobei das genannte zusätzliche magnetische Wechselfeld eine andere Richtung als das Erregerfeld hat.

5. Magnetometer nach Anspruch 4, **dadurch gekennzeichnet, dass** der leitfähige Draht eine den Magnetkern (1) umgebende Wicklung (19, 20) ist.

6. Magnetometer nach Anspruch 4, **dadurch gekennzeichnet, dass** es ebenso viele leitfähige Drähte umfasst wie der Kern (1) Schenkel (2, 3) hat, wobei die Drähte jeweils nahe bei den Schenkeln sind und parallel zu den Schenkeln sind.
